# EUROPEAN PATENT APPLICATION

(11) **EP 4 328 977 A1**
(43) Date of publication of application: **28.02.2024**
(21) Application number: 22208613.4
(22) Date of filing: 21.11.2022
(51) Int. Cl.: H01L 29/78, H01L 29/06, H01L 29/40

(54) **LATERALLY DIFFUSED METAL OXIDE SEMICONDUCTOR STRUCTURE**

(30) Priority: 25.08.2022 TW 111132084
(71) Applicant: United Microelectronics Corp., Hsin-Chu City 300 (TW)
(72) Inventor: LIN, Zong-Han, 732 Tainan City (TW)
(74) Representative: Isarpatent

(57) **Abstract**

The invention provides a laterally diffused metal-oxide-semiconductor (LDMOS), which comprises a substrate, a plurality of fin structures on the substrate, a gate structure on the substrate and spanning the fin structures, and a gate contact layer on the gate structure, wherein the gate contact layer is electrically connected with a dummy contact structure.

## Description

### Background of the Invention

The present invention relates to semiconductor transistor devices, in particular to a lateral diffused metal oxide semiconductor (LDMOS) transistor device with an extended field plate.

The laterally diffused metal oxide semiconductor (LDMOS) device is a common power semiconductor device. Because of the horizontal structure of the LDMOS device, it is easy to be manufactured and be integrated with the current semiconductor technology, thus reducing the manufacturing cost. At the same time, it can withstand high breakdown voltage and has high output power, so it is widely used in power converter, power amplifier, switch, rectifier and other components.

However, the traditional LDMOS still has some shortcomings that need to be improved, such as high on-resistance (Ron), high off current (Ioff) and short hot carrier injection life-time. Therefore, it is necessary to propose a more advanced LDMOS to improve the above shortcomings.

### Summary of the Invention

The invention provides a laterally diffused metal oxide semiconductor (LDMOS), which comprises a substrate, a plurality of fin structures on the substrate, a gate structure on the substrate and spanning the fin structures, and a gate contact layer on the gate structure, wherein the gate contact layer is electrically connected with a dummy contact structure.

The invention is characterized in that a gate contact layer is formed on the gate structure of the LDMOS, and the gate contact layer can be used as a field plate of the LDMOS. The gate contact layer has the functions of dispersing electric field and inhibiting Kirk effect. In addition, the gate contact layer of the invention is further directly connected with the dummy contact structure located on the shallow trench isolation. Without adding process steps, the field plate can be further extended, the current can be more dispersed and the quality of the LDMOS can be improved. According to the experimental results of the applicant, the structure of the present invention has the advantages of reducing the off current (Ioff), reducing the on resistance (Ron), increasing the hot carrier injection life-time, and increasing the breakdown voltage (Vbd).

These and other objectives of the present invention will no doubt become obvious to those of ordinary skill in the art after reading the following detailed description of the preferred embodiment that is illustrated in the various figures and drawings.

### Brief Description of the Drawings

Fig. 1 shows a top view of a laterally diffused metal oxide semiconductor (LDMOS) according to a first preferred embodiment of the present invention.
Fig. 2 is a cross-sectional view taken along the section line A-A' in Fig. 1.
Fig. 3 is a cross-sectional view taken along the section line B-B' in Fig. 1.
Fig. 4 is a top view of a laterally diffused metal oxide semiconductor (LDMOS) according to a second preferred embodiment of the present invention.
Fig. 5 is a cross-sectional view taken along the section line C-C' in Fig. 4.

### Detailed Description

To provide a better understanding of the present invention to users skilled in the technology of the present invention, preferred embodiments are detailed as follows. The preferred embodiments of the present invention are illustrated in the accompanying drawings with numbered elements to clarify the contents and the effects to be achieved.

Please note that the figures are only for illustration and the figures may not be to scale. The scale may be further modified according to different design considerations. When referring to the words "up" or "down" that describe the relationship between components in the text, it is well known in the art and should be clearly understood that these words refer to relative positions that can be inverted to obtain a similar structure, and these structures should therefore not be precluded from the scope of the claims in the present invention.

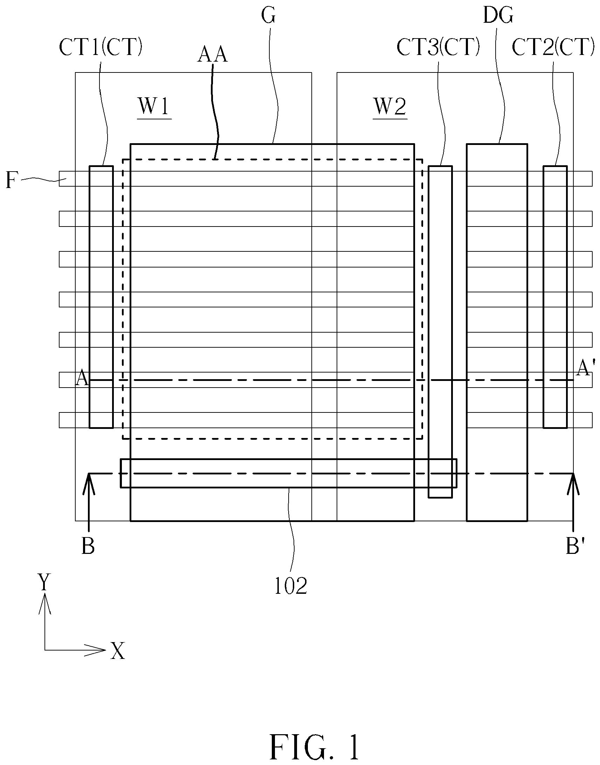

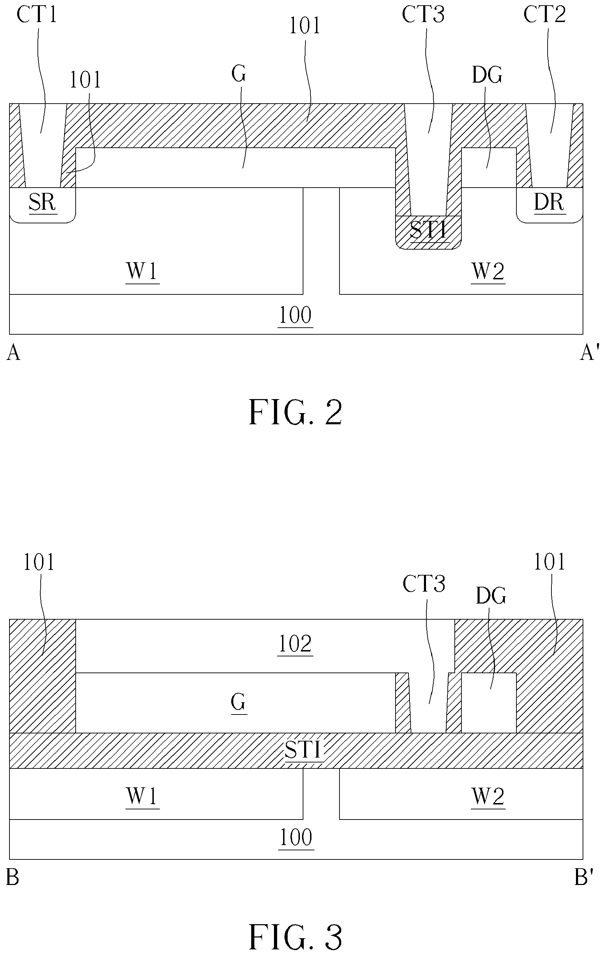

Fig. 1 shows a top view of a laterally diffused metal oxide semiconductor (LDMOS) according to a first preferred embodiment of the present invention, Fig. 2 shows a cross-sectional view taken along section line A-A' in Fig. 1, and Fig. 3 shows a cross-sectional view taken along section line B-B' in Fig. 1. As shown in Fig. 1, Fig. 2 and Fig. 3, an LDMOS according to the first embodiment of the present invention includes a substrate 100, which is made of, for example, a silicon substrate or a silicon on insulation (SOI) substrate. In this embodiment, the substrate 100 has a first conductivity type (e.g., P-type), and a plurality of fin structures F are formed on the substrate 100 by etching or other methods. The material of the fin structures F is preferably the same as that of the substrate 100 (e.g., microsilica), and the fin structures F are arranged in parallel with each other along the same direction, for example, along the X-axis in Fig. 1. In addition, as shown in Fig. 2, a first well region W1 and a second well region W2 are formed in the substrate 100 by ion implantation, wherein the first well region W1 includes the first conductivity type (e.g., P-type) and the second well region W2 includes a second conductivity type (e.g., N-type). Besides, the first well region W1 and the second well region W2 are not in direct contact with each other. As shown in Fig. 2, there is still a part of the substrate 100 between the first well region W1 and the second well region W2 that is not doped, so as to serve as the channel region of the subsequent LDMOS. The first well region W1 also contains a source region SR and the second well region W2 also contains a drain region DR, wherein both the source region SR and the drain region DR contain the second conductivity type (for example, N-type), and the doping concentration of the source region SR and the drain region DR is higher than the ion doping concentration of the second well region W2. It should be noted that the LDMOS in this embodiment is an N-type LDMOS, so the substrate 100 and the first well region W1 are P-type, and the second well region W2, the source region SR and the drain region DR are N-type, but the present invention is not limited to this. The present invention also includes P-type LDMOS, that is to say, the conductivity types of the above elements are not limited by this embodiment.

Next, please continue to refer to Fig. 1 and Fig. 2. The substrate 100 contains shallow trench isolation STI, wherein the shallow trench isolation STI is made of insulating materials such as silicon oxide or silicon nitride, and the fin structure F is exposed. It is worth noting that in the second well region W2, for example, part of the fin structure F is cut off and a groove is formed by etching, and then the shallow trench isolation STI is formed and filled in the groove. Therefore, from the view of Fig. 2, the shallow trench isolation STI will also be formed in the second well region W2 and penetrate into a part of the second well region W2. Here, the shallow trench isolation STI is formed in the second well region W2, so that when the switch of LDMOS is turned on, the current (not shown) will flow from the source region SR to the drain region DR through the region below the STI, thus prolonging the path of the current, and increasing the breakdown voltage (Vbd) of the LDMOS and increasing the stability of the LDMOS.

In addition, the substrate 100 includes an interlayer dielectric (ILD) 101, and a plurality of gate structures G, a plurality of dummy gate structures DG and a plurality of contact structures CT are located in the interlayer dielectric 101. The gate structures G and dummy gate structures DG here span a plurality of fin structures F along the Y-axis direction, and the materials of the gate structures G and dummy gate structures DG are, for example, polycrystalline silicon, but are not limited to this, and may be metal materials in other embodiments. The gate structure G is located on the substrate 100 and crosses the first well region W1 and the second well region W2 along the X-axis direction, while the dummy gate structure DG is located on the second well region W2. In addition, a plurality of contact structures CT are formed to electrically connect the source region SR and the drain region DR respectively, and at least one contact structure is located on the shallow trench isolation STI. For convenience, the contact structure CT electrically connected with the source region SR is defined as a source contact structure CT1, the contact structure CT electrically connected with the drain region DR is defined as a drain contact structure CT2, and the contact structure CT on the shallow trench isolation STI is defined as a dummy contact structure CT3, where the dummy contact structure CT3 is not actually connected with the electronic component. In this embodiment, the contact structure CT (e.g., CT1 or CT2) is made of the same material as the dummy contact structure CT3, and is preferably manufactured in the same step. In this embodiment, the purpose of forming the dummy contact structure CT3 and the dummy gate structure DG is to improve the uniformity of the pattern during the manufacturing process, and to avoid the large difference in pattern density that will affect the quality of pattern generation.

Then, as shown in Fig. 3, a gate contact layer 102 is formed on the gate structure G, and the gate contact layer 102 is used for electrically connecting with other subsequent contact structures (not shown). Note that the arrangement direction of the gate contact layer 102 in this embodiment is the same as that of the fin structure F, but the gate contact layer 102 is not located directly above the fin structure F. In other words, the region of the fin structure F can be defined as an active area AA, and the gate contact layer 102 is located outside the active area AA. However, it should be noted that in other embodiments of the present invention, the gate contact layer 102 may also be located in the active region AA, and such a structure also belongs to the scope of the present invention.

It is worth noting that in this embodiment, the gate contact layer 102 is also directly connected with the dummy contact structure CT3 nearby. In the actual process, after the gate structures G and the dummy gate structures DG are formed, the grooves of the contact structures CT (including the source contact structure CT1, the drain contact structure CT2 and the dummy contact structure CT3) and the grooves of the gate contact layer 102 can be formed in the interlayer dielectric 101, and then the conductive layer can be filled into these grooves at the same time to simultaneously form the source contact structure CT1, the drain contact structure CT2, the dummy contact structure CT3 and the gate contact layer 102. That is, the gate contact layer 102 and the dummy contact structure CT3 can be integrally formed structures (made of the same material and formed in the same step). In addition, since both of them are formed at the same time, it is preferable that the top surface of the gate contact layer 102 and the top surface of the dummy contact structure CT3 are aligned with each other.

In this embodiment, the gate contact layer 102 can be used as a layer for electrically connecting other subsequent contact structures, and the gate contact layer 102 located on the gate structure G can also be formed as a filed plate. The "field plate" here means that the gate structure G straddles the insulating layer to disperse the electric field. More specifically, when the LDMOS is turned on, the surface electric field at the end of the channel is concentrated, so it is easy to cause a punch through phenomenon. After the gate structure G is covered with the gate contact layer 102, the gate contact layer 102 connects with the gate structure G to produce an extension effect and form a field plate, which has the function of dispersing the electric field, thus avoiding the above-mentioned punch through phenomenon caused by the excessive concentration of the electric field at the end of the channel. In addition, in the present invention, the gate contact layer 102 is directly connected to the dummy contact structure CT3, so that the field plate can be further extended, and the electric field can be further dispersed, thus achieving the effect of improving the quality of LDMOS.

In the present invention, the gate contact layer 102 is directly connected to the dummy contact structure CT3. Compared with the embodiment in which the gate contact layer 102 and the dummy contact structure CT3 are simply formed but not connected, the present invention obviously improves the performance of the LDMOS. According to the experimental results of the applicant, compared with the embodiment without connecting the gate contact layer 102 to the dummy contact structure CT3, this embodiment can reduce the off-current (Ioff) by about 40%, reduce the on-resistance (Ron) by about 6%, enhance the hot carrier injection life-time by about 20%, and enhance the breakdown voltage (Vbd) by about 1% by connecting the gate contact layer 102 to the dummy contact structure CT3. All the above parameters are beneficial to improve the quality of the LDMOS. In addition, the method adopted in this embodiment is also compatible with the existing process, and no additional process steps are added.

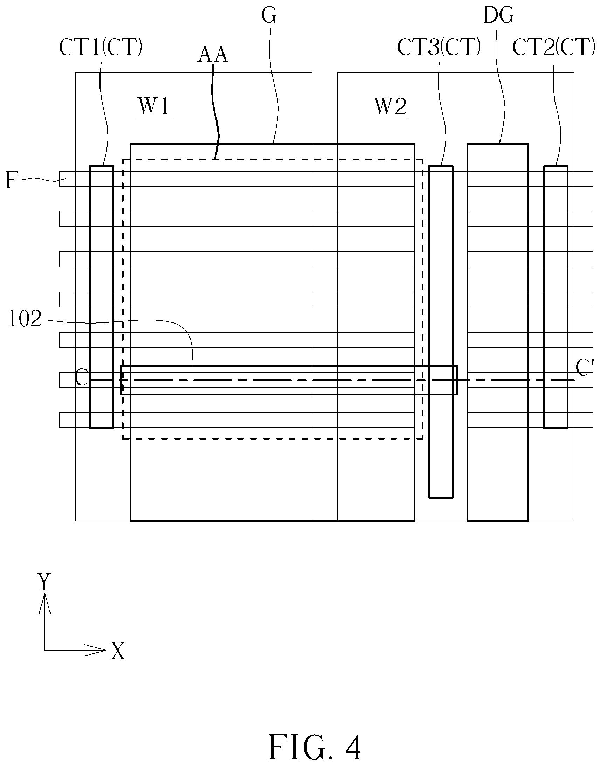

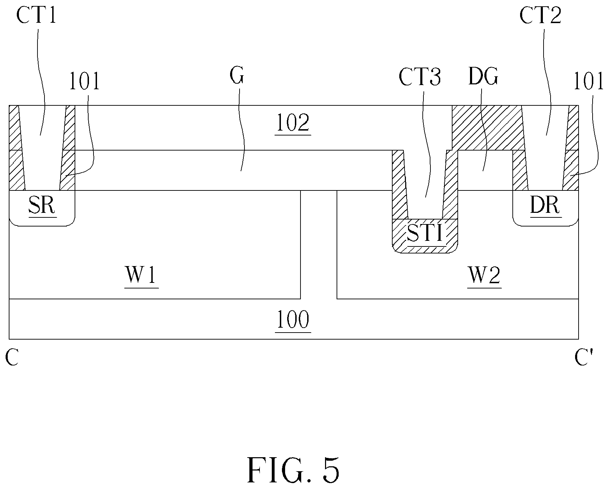

Fig. 4 is a top view of a laterally diffused metal oxide semiconductor (LDMOS) according to a second preferred embodiment of the present invention, and Fig. 5 is a cross-sectional view taken according to the section line C-C' in Fig. 4. This embodiment also proposes an LDMOS, and most of the components are the same as those described in the above embodiments, including the substrate 100, the fin structure F, the first well region W1, the second well region W2, the shallow trench isolation STI, the source region SR, the drain region DR, the interlayer dielectric 101, the gate structure G, the dummy gate structure DG, the source contact structure CT1, the drain contact structure CT2, the dummy contact structure CT3, etc. The difference between this embodiment and the above embodiments is that the gate contact layer 102 in this embodiment is located directly above the region where the fin structure F is located, that is, directly above the active region AA. Similarly, in this embodiment, the gate contact layer 102 is directly connected to the nearby dummy contact structure CT3. As shown in Fig. 5, the gate contact layer 102 is also connected to the nearby dummy contact structure CT3 and presents a cross-sectional structure similar to a right angle, that is, it has two parts, namely, the gate contact layer 102 extending transversely and the dummy contact structure CT3 extending longitudinally, and both of them are integrally formed. Similar to the above embodiment, the structure of this embodiment also has an extended field plate, so the quality of LDMOS can be improved. Except for the above features, other features are the same as those of the above embodiment, so they are not repeated here.

According to the above description and drawings, the present invention provides a laterally diffused metal-oxide-semiconductor (LDMOS), which comprises a substrate 100, a plurality of fin structures F located on the substrate 100, a gate structure G located on the substrate 100 and spanning the plurality of fin structures F, and a gate contact layer 102 located on the gate structure G and electrically connected to the gate structure G, wherein the gate contact layer 102 is electrically connected to a dummy contact structure CT3.

In some embodiments of the present invention, a first well region W1 and a second well region W2 are located in the substrate 100, and a shallow trench isolation STI is located in the second well region W2.

In some embodiments of the present invention, the dummy contact structure CT3 is located on the STI and directly contacts the STI.

In some embodiments of the present invention, it further includes a source contact (contact structure CT1) on the first well region W1 and a drain contact (contact structure CT2) on the second well region W2.

In some embodiments of the present invention, the first well region is P-type and the second well region is N-type.

In some embodiments of the present invention, the first well region W1 further comprises a source region SR, and the second well region W2 further comprises a drain region DR.

In some embodiments of the present invention, the source contact structure CT1 is electrically connected to the source region SR, and the drain contact structure CT2 is electrically connected to the drain region DR.

In some embodiments of the present invention, it further includes a dummy gate structure DG located between the dummy contact structure CT3 and the drain contact structure CT2.

In some embodiments of the present invention, the gate structure G spans part of the first well region W1 and part of the second well region W2, and the dummy contact structure CT3 is located beside the gate structure G.

In some embodiments of the present invention, a top surface of the gate contact layer 102 is aligned with a top surface of the dummy contact structure CT3.

In some embodiments of the present invention, the gate contact layer 102 and the plurality of fin structures F extend along a first direction (for example, they are arranged parallel to each other along the X-axis in Fig. 1).

In some embodiments of the present invention, the dummy contact structure CT3 extends along a second direction (e.g., the Y-axis in Fig. 1), and the first direction is different from the second direction.

In some embodiments of the present invention, the region where the fin structures F are located is defined as an active area AA, and the gate contact layer 102 is located outside the active area AA.

In some embodiments of the present invention, the region where the fin structures F are located is defined as an active area AA, and the gate contact layer 102 is located in the active area AA.

In some embodiments of the present invention, the gate contact layer 102 is made of the same material as the dummy contact structure CT3.

In some embodiments of the present invention, a bottom surface of the dummy contact structure CT3 is lower than a bottom surface of the gate contact layer 102 (as shown in Fig. 3 or Fig. 5) or lower than a bottom surface of the dummy gate structure DG (as shown in Fig. 2).

The invention is characterized in that a gate contact layer is formed on the gate structure of the LDMOS, the gate contact layer can be used as a field plate of the LDMOS, and it has the functions of dispersing electric field and inhibiting Kirk effect. In addition, the gate contact layer of the invention is further directly connected with the dummy contact structure located on the shallow trench isolation. Without adding process steps, the field plate can be further extended, and the current can be more dispersed and the quality of the LDMOS can be improved. According to the experimental results of the applicant, the structure of the present invention has the advantages of reducing the off current (Ioff), reducing the on resistance (Ron), increasing the hot carrier injection life-time, and increasing the breakdown voltage (Vbd).

## Claims

1. A laterally diffused metal-oxide-semiconductor, LDMOS, comprising:
a substrate (100);
a plurality of fin structures (F) located on the substrate (100);
a gate structure (G) located on the substrate (100) and spanning the plurality of fin structures (F); and
a gate contact layer (102) located on the gate structure (G) and electrically connected to the gate structure (G), wherein the gate contact layer (102) is electrically connected to a dummy contact structure (CT3).

2. The LDMOS according to claim 1, further comprising a first well region (W1) and a second well region (W2) located in the substrate (100), and a shallow trench isolation (STI) in the second well region (W2).

3. The LDMOS according to claim 2, wherein the dummy contact structure (CT3) is located on the shallow trench isolation (STI) and directly contacts the shallow trench isolation (STI).

4. The LDMOS according to claim 2, further comprising a source contact (CT1) on the first well region (W1) and a drain contact (CT2) on the second well region (W2).

5. The LDMOS according to claim 4, wherein the first well region (W1) is P-type and the second well region (W2) is N-type.

6. The LDMOS according to claim 4 or 5, wherein the first well region (W1) further comprises a source region (SR) and the second well region (W2) further comprises a drain region (DR).

7. The LDMOS according to claim 6, wherein the source contact (CT1) is electrically connected to the source region (SR) and the drain contact (CT2) is electrically connected to the drain region (DR).

8. The LDMOS according to any one of claim 4 to 7, further comprising a dummy gate structure (DG) located between the dummy contact structure (CT3) and the drain contact (CT2).

9. The LDMOS according to any one of claim 2 to 8, wherein the gate structure (G) spans part of the first well region (W1) and part of the second well region (W2), and the dummy contact structure (CT3) is located beside the gate structure (G).

10. The LDMOS according to one of the preceding claims, wherein a top surface of the gate contact layer (102) is aligned with a top surface of the dummy contact structure (CT3).

11. The LDMOS according to one of the preceding claims, wherein the gate contact layer (102) and the plurality of fin structures (F) extend along a first direction.

12. The LDMOS according to claim 11, wherein the dummy contact structure (CT3) extends along a second direction, and the first direction is different from the second direction.

13. The LDMOS according to one of the preceding claims, wherein an area where the fin structures (F) are located is defined as an active area (AA), and the gate contact layer (102) is located outside the active area (AA).

14. The LDMOS according to one of the preceding claims, wherein an area where the fin structures (F) are located is defined as an active area (AA), and the gate contact layer (102) is located in the active area (AA).

15. The LDMOS according to one of the preceding claims, wherein a material of the gate contact layer (102) is same as a material of the dummy contact (CT3), or wherein a bottom surface of the dummy contact (CT3) is lower than a bottom surface of the gate contact layer (102).
